# EUROPÄISCHE PATENTSCHRIFT

(11) **EP 0 964 512 B1**
(45) Veröffentlichungstag und Bekanntmachung des Hinweises auf die Patenterteilung: **26.11.2003**
(21) Anmeldenummer: 99111246.7
(22) Anmeldetag: 09.06.1999
(51) Int. Cl.: H03G 7/00

(54) **Signalkomprimierer für Audiogerät**
Signal compression for audio device
Compresseur de signal pour dispositif audio

(30) Priorität: 12.06.1998 DE 19826389
(43) Veröffentlichungstag der Anmeldung: 15.12.1999
(73) Patentinhaber: STMicroelectronics GmbH, 85630 Grasbrunn (DE)
(72) Erfinder: Lübbe, Jürgen, D-83553 Jacobneuharting (DE); Henkel, Johann, D-83024 Rosenheim (DE); Kirchlechner, Peter, D-83104 Hohenthann (DE)
(74) Vertreter: Hirsch, Peter, Dipl.-Ing.

(56) Entgegenhaltungen:
- DE-A- 3 220 670
- US-A- 4 628 526
- US-A- 5 633 939

## Beschreibung

Die Erfindung betrifft einen Signalkomprimierer für ein Audiogerät, insbesondere Kraftfahrzeug-Audiogerät, welches einen in den Audiosignalweg einfügten Lautstärkeregler enthält, der über ein digitales Stellsignal einstellbar ist, das von einem digitalen Steller geliefert wird.

Insbesondere bei Massenartikeln wie z. B. Audioanlagen für Kraftfahrzeuge, die zumindest ein Radio, neuerdings auch zusätzlich ein Kassettenteil und ein CD-Teil enthalten, ist es nicht nur zur Senkung der Fertigungskosten erstrebenswert, möglichst viele Schaltungsteile in einer integrierten Schaltung zusammenzufassen. Integrierte Schaltungen können auch mit sehr komfortablen Merkmalen ausgestattet sein, die die Handhabung erleichtern und das Klangverhalten verbessern.

Es ist Stand der Technik, zahlreiche Einzelkomponenten eines Audiogeräts in einem sogenannten Audioprozessor zusammenzufassen. Allerdings werden bestimmte Funktionen nach wie vor durch diskrete Bauelemente oder Baugruppen realisiert, die nicht als integrierte Schaltung ausgebildet werden konnten.

Bei der vorliegenden Erfindung geht es um die Signalkompression zum dynamischen Komprimieren der Audiosignale. Abhängig von der Beschaffenheit des Speichermediums haben Audiosignale, insbesondere bei beispielsweise klassischer Musik, einen großen dynamischen Bereich (z. B. 85 dB). Dieser große dynamische Bereich spiegelt im wesentlichen die Situation in einem Konzertsaal wieder. In einem Musikstück gibt es sehr leise Stellen und extrem laute Stellen. Während die getreue Wiedergabe dieser sehr leisen und sehr lauten Stellen eines Musikstücks an sich erstrebenswert ist, führt der hohe dynamische Bereich bei Kraftfahrzeug-Audioanlagen und anderen Anlagen, die in Umgebungen mit hohem Hintergrund-Geräuschpegel betrieben werden, häufig zu unerwünschten Effekten: leise Stellen sind aufgrund des hohen Hintergrund-Geräuschpegels fast nicht zu hören, laute Stellen werden als störend empfunden, insbesondere dann, wenn sie von einer anderen Tätigkeit, z. B. dem Führen eines Kraftfahrzeugs, ablenken.

Aus diesem Grund ist es bereits bekannt, bei einem Audiogerät einen Signalkomprimierer vorzusehen, der den sehr großen dynamischen Bereich des Audiosignals verkleinert, z. B. von 85 dB auf 60 dB. Der Effekt eines solchen Signalkomprimierers besteht darin, daß die Lautstärke bei sehr leisen Stellen eines Musikstücks erhöht wird, während die Lautstärke bei sehr lauten Stellen vermindert wird.

Die Anmelderin hat bereits einen Signalkomprimierer entwickelt, der in Verbindung mit einem weitestgehend digital arbeitenden Audioprozessor verwendet wird. Zum Beispiel wird mit einem dem Audioprozessor vorgeschalteten Signalkomprimierer das unkomprimierte Ausgangssignal von einem CD-Gerät (Compact-Disc-Gerät) in den Signalkomprimierer geleitet, dort komprimiert, und das komprimierte Ausgangssignal wird dem Audioprozessor zugeleitet.

Bislang waren diese Signalkomprimierer als analog arbeitende Schaltungen ausgebildet. Um die gewünschte Signalkompression des Analogsignals zu erreichen, wurden Widerstände und Kondensatoren eingesetzt. Solche üblicherweise als externe Bauelemente zusätzlich zu integrierten Bauelementen verwendeten Komponenten stehen einer kostengünstigen Massenproduktion entgegen und sollten vermieden werden.

Um das nicht-komprimierte Signal in ein komprimiertes Signal umzuwandeln, erfolgt typischerweise eine Analog-Multiplikation des nichtkomprimierten Analogsignals mit einem angemessenen Faktor.

Nachteilig bei dem bekannten Multiplizierer ist allerdings, daß das gewonnene komprimierte Signal eine starke Verzerrung aufweist, insbesondere bei Eingangssignalen mit hohem Pegel.

Da der als separate Komponente ausgeführte bekannte Signalkomprimierer eine Reihe aktiver Signalverarbeitungsstufen aufweist, verschlechtert sich der Rauschabstand (S/N-Verhältnis) des Signals, insbesondere bei geringen Signalpegeln.

Der Erfindung liegt die Aufgabe zugrunde, einen Signalkomprimierer für ein Audiogerät zu schaffen, mit dessen Hilfe sich die gewünschte Signalkompression unter Verwendung vergleichsweise weniger Bauelemente realisieren läßt. Insbesondere soll durch Einsparung von Bauelementen des gesamten Audiogeräts Platz gespart werden, und die Fertigung soll billiger werden.

Durch die Erfindung soll weiterhin erreicht werden, daß das bei den bisher üblichen Signalkomprimierern unvermeidbar entstandene Klirren und Rauschen vermindert wird.

Hierzu schafft die Erfindung einen Signalkomprimierer des eingangs genannten Typs, der folgende Merkmale aufweist:
a) von dem Audiosignalweg vor dem Lautstärkeregler wird das Audiosignal abgezweigt und von einer Signalverarbeitungsschaltung zu einem Nachführsignal verarbeitet, das von der Stärke des Audiosignals abhängt;
b) das Nachführsignal wird in einem Komparator mit einem Referenzwert verglichen;
c) abhängig von dem Vergleichsergebnis wird ein als Auf-/Ab-Zähler ausgebildeter Zähler erhöht oder erniedrigt, und
d) der Inhalt des Zählers wird mit dem digitalen Stellsignal verknüpft, bevor das Stellsignal dem Lautstärkeregler zugeführt wird.

Günstige Voraussetzung für die Erfindung ist ein Gerät mit einem Lautstärkeregler, der durch ein digitales Stellsignal eingestellt wird. Ein solcher Lautstärkeregler wurde von der Anmelderin bereits entwickelt (DE-A-195 27 338). Die Besonderheit bei diesem bekannten Lautstärkeregler besteht darin, daß der Pegel des analogen Audiosignals am Eingang des Lautstärkereglers auf der Grundlage eines digitalen Stellsignals verändert wird, wobei Maßnahmen getroffen sind, daß bei einer Änderung der Lautstärke ein sanfter Signalübergang ohne jedes "Klickgeräusch" erfolgt. Ändert sich der digitale Wert des Stellsignals (was nur sprunghaft geschehen kann), so würde normalerweise das Audiosignal am Ausgang des Lautstärkereglers einen Amplitudensprung machen, der sich als unangenehmes "Klickgeräusch" bemerkbar machte. Durch in der genannten DE-A-195 27 338 im einzelnen beschriebene Maßnahmen wird erreicht, daß dieser Signalübergang am Ausgang des Lautstärkereglers in jedem Fall sanft und gleitend erfolgt, also ein Klickgeräusch vermieden wird.

Der bekannte Lautstärkeregler besitzt einen Digital-Eingang für das digitale Stellsignal. Die Erfindung nutzt diesen Umstand, indem dieses digitale Stellsignal abhängig vom Pegel des Audio-Eingangssignals modifiziert wird. Das von dem Pegel des Audiosignals vor dem Lautstärkeregler abhängige Nachführsignal wird mit einem Referenzsignal verglichen, und abhängig von dem Vergleichsergebnis wird der Zählerstand eines Auf-/Ab-Zählers geändert. Der Inhalt des Zählers wird dann in geeigneter Weise mit dem digitalen Stellsignal verknüpft.

Die möglichen verschiedenen Verknüpfungsarten werden weiter unten näher erläutert. In jedem Fall wird erreicht, daß sehr schwache Pegel des Audiosignals bewirken, daß der Lautstärkeregler das Signal zusätzlich in Richtung größerer Lautstärke verändert, während bei hohen Pegeln des Audiosignals der Lautstärkeregler eine Änderung des Audiosignals im Sinne einer Lautstärkeverminderung vornimmt.

Wie im folgenden noch deutlich werden wird, lassen sich die zur Lösung der erfindungsgemäßen Aufgabe benötigten Komponenten des Signalkomprimierers vollständig als integrierte Schaltung ausführen. Da zum Teil Gebrauch gemacht wird von bereits vorhandenen Komponenten im Audioprozessor, wird gegenüber der früheren Lösung, d. h. einer Signalkompression mit Hilfe eines eigenständigen Signalkomprimierers, erheblicher Platz für die Schaltung auf der Schaltungsplatine eingespart.

Da im Gegensatz zum Stand der Technik keine Multiplikation von Analogsignalen benötigt wird, wird das in der Stärke veränderte Audiosignal kaum verzerrt. Da keine zusätzlichen Komponenten im eigentlichen Signalpfad erforderlich sind, wird der Signal-Rauschabstand nicht beeinflußt.

Die oben angesprochene Verknüpfung des digitalen Stellsignals mit dem Inhalt des Zählers kann auf verschiedene Weise durchgeführt werden.

In einer möglichen und bevorzugten Ausführungsform ist ein Addierer vorgesehen, auf dessen ersten Eingang das digitale Stellsignal gegeben wird, und dessen zweiter Eingang mit dem Ausgang des Zählers gekoppelt ist, wobei der Zähler von dem Ausgangssignal des Komparators erhöht wird, wenn das Nachführsignal einem verringerten Pegel des Audiosignals entspricht.

Um die Wirkungsweise dieser speziellen Ausführungsform mit dem Addierer zu verdeutlichen, seien einige Zahlenbeispiele verwendet: wenn das digitale Stellsignal für den Lautstärkeregler 8 Bits umfaßt, sind theoretisch 256 Lautstärkestufen möglich. Es sei angenommen, der Lautstärkeregler sei auf die Stufe "100" eingestellt, d. h., das digitale Stellsignal sei die binäre Darstellung des Dezimalwerts "100". Wenn der Auf-/Ab-Zähler sechs Stellen aufweist, läßt sich mit seinem Inhalt jeder Wert zwischen 0 und +63 darstellen. Hat das Audiosignal einen mittleren Pegel, so soll der Inhalt des Zählers z. B. dem Wert "30" entsprechen. Durch die Addition mit dem oben genannten Wert "100" ist dann der Lautstärkeregler tatsächlich auf einen Wert "130" eingestellt.

Hat das Audiosignal nun einen sehr schwachen Pegel, so wird ein entsprechend niedriges Nachführsignal gebildet, welches z.B. größer ist als das Referenzsignal, demzufolge das Ausgangssignal des Komparators den Inhalt des Zählers erhöht. Das Ausmaß der Erhöhung des Zählers hängt davon ab, wie tief der Pegel des Audiosignals sinkt. Bei extrem geringen Pegeln des Audiosignals wird der Zähler entsprechend stark erhöht, maximal bis auf den Wert "63". Dieser Wert "63" wird auf den erwähnten Wert von "100" addiert, so daß der Lautstärkeregler tatsächlich eine Lautstärke entsprechend dem Wert "163" einstellt.

Bei sehr starken Pegeln des Audiosignals wird der Zähler so betrieben, daß sein Zählerstand niedriger wird. Im Ergebnis liefert dann der Lautstärkeregler ein Signal, welches dem Einstellwert von im Extremfall "100" entspricht, also dem Wert des digitalen Stellsignals.

Den oben erläuterten Effekt kann man auch erreichen, wenn man in einer weiteren bevorzugten Ausführungsform der Erfindung statt des Addierers einen Subtrahierer verwendet. In diesem Fall wird dann der Zählerstand bei sehr niedrigem Pegel des Audiosignals erniedrigt. Die von dem Subtrahierer durchgeführte Subtraktion führt also bei schwachen Pegeln des Audiosignals zu einer nur geringfügigen Verringerung des dem digitalen Stellsignals entsprechenden Zahlenwert, so daß schwache Audiosignale relativ angehoben werden, wohingegen bei starken Audiosignalen am Eingang des Lautstärkereglers ein entsprechend großer Wert von dem digitalen Stellsignal subtrahiert wird. Hohe Lautstärken werden also abgeschwächt.

Außer den beiden angesprochenen Varianten sind noch andere Abwandlungen und Ausführungsformen für die Verknüpfung des digitalen Stellsignals mit dem Ausgangssignal des Zählers möglich: man kann auch eine digitale Multiplikation durchführen. Bei mittleren Signalpegeln des Audiosignals würde dann der Wert des digitalen Stellsignals mehr oder weniger unverändert bleiben (Multiplikationsfaktor "1"), während bei niedrigen Signalpegeln des Audiosignals eine Anhebung der Lautstärke erreicht würde (Multiplikationsfaktor zwischen 1,01 und 1,15). Bei sehr hohen Audiosignal-Pegeln würde die Multiplikation zu einer Verringerung der Lautstärke führen (Multiplikationsfaktor z. B. zwischen 0,85 und 0,99).

Um eine "gleitende" Kompression des Eingangs-Audiosignals in dem gesamten Pegelbereich zu erhalten, ist erfindungsgemäß vorgesehen, daß der zur Analogsignalverarbeitung ausgebildete Komparator mit einem Eingang über einen D/A-Wandler an den Ausgang des Zählers und mit seinem anderen Eingang an den Ausgang der Signalverarbeitungsschaltung angeschlossen ist. Das Referenzsignal, welches der Komparator mit dem Nachführsignal vergleicht, entspricht also dem aktuellen Zählerstand des Auf-/Ab-Zählers. Bei einem extrem schwachen Audiosignal beispielsweise ist das Nachführsignal höher als das Referenzsignal, demzufolge der Zählerstand erhöht wird (falls ein Addierer nachgeschaltet ist). Damit erhöht sich auch der Wert des Referenzsignals. Anschließend erfolgt eine weitere Erhöhung des Zählerstands, solange das Nachführsignal höher ist als das Referenzsignal. Durch das stufenweise Ansteigen des Referenzsignals wird dann schließlich ein Zustand erreicht, in dem das Nachführsignal kleiner ist als das Referenzsignal, so daß der Zählerstand dann nicht weiter erhöht wird.

Anstatt den digitalen Zählerstand in ein Analogsignal umzusetzen und dieses Analogsignal dann als Referenzsignal zusammen mit dem analogen Nachführsignal auf den Komparator zu geben, ist in einer anderen bevorzugten Ausführungsform der Erfindung vorgesehen, daß der als Digitalsignal-Vergleicher ausgebildete Komparator mit einem Eingang über einen A/D-Wandler an den Ausgang der Signalverarbeitungsschaltung und mit dem anderen Eingang an den Ausgang des Zählers angeschlossen ist. Diese alternative Schaltung mit dem digital arbeitenden Vergleicher liefert im Endergebnis die gleichen Signale zum Erhöhen oder vermindern des Zählerstands des Auf-/Ab-Zählers. Die oben angesprochenen Signale, die dem Auf-/Ab-Zähler zugeführt werden, sind die Signale, die festlegen, ob der Zählerstand erhöht oder vermindert wird. Der eigentliche Zählvorgang hängt von dem dem Zähler zugeführten Taktsignal ab. Dabei ist der Zähler so ausgebildet, daß bei unterschiedlichen Pegeln zweier von dem Komparator kommender Signale "Auf" und "Ab" eine entsprechende Änderung des Zählerstands um "1" erfolgt, und zwar abhängig von dem zugeführten Taktsignal. Haben die beiden Signale "Auf" und "Ab" gleiche Pegel, so bewirkt das Taktsignal keinen Zählvorgang.

Das Komprimieren des dynamischen Signalbereichs mit Hilfe der erfindungsgemäßen Signalkomprimierschaltung sollte natürlich in der Weise vonstatten gehen, daß sich die Musik aufgrund unerwarteter Lautstärkeänderungen nicht fremd anhört. Plötzlich auftretende hohe Lautstärken können insbesondere für den Führer eines Kraftfahrzeugs unerwünscht sein. Um dies zu vermeiden, und um andererseits einen möglichst sanften Übergang im komprimierten Signal zu erreichen, sieht die Erfindung vor, daß der Ausgang des Komparators mit einem Zählrichtungseingang des Zählers gekoppelt ist, und daß der Zähler abhängig davon, ob die Audiosignal-Stärke zunimmt oder abnimmt, mit einem Taktsignal einer ersten Frequenz bzw. einem Taktsignal einer zweiten Frequenz, die niedriger ist als die erste Frequenz, getaktet wird.

Dadurch wird erreicht, daß die Pegelabsenkung bei stärker werdendem Audiosignal in kürzerer Zeit durchgeführt wird als eine entsprechend große Pegelanhebung bei schwächer werdendem Audiosignal. Die Pegelabsenkung bei ansteigendem Audiosignal wird in kürzerer Zeit bewirkt, um zu verhindern, daß es bei stark zunehmendem Audiosignal zu einer Amplitudenbeschneidung kommt. Die Pegelanhebung bei schwächer werdendem Audiosignal wird langsamer vorgenommen, um einen Pump-Effekt bei sich stark änderndem Audiosignal zu verhindern. Auf diese Weise wird das Ausgangssignal beruhigt.

Das Taktsignal der ersten, relativ hohen Frequenz sorgt dafür, daß bei starkem Pegelanstieg ein Clipping des Signals verhindert wird. Die zweite, relativ geringe Frequenz, die bei abnehmendem Pegel maßgeblich ist, soll das Ausgangssignal beruhigen, insbesondere soll vermieden werden, daß es bei sich stark ändernden Signalen zu einem Pump-Effekt kommt.

Das Taktsignal zum Takten des Zählers wird von einem Oszillator gewonnen, der aus einem Signal relativ hoher Frequenz f1 durch Division oder Frequenzteilung ein Taktsignal mit einer Frequenz f2 bildet, die einem Bruchteil der Frequenz f1 entspricht. Ob dem Zähler das Signal höherer oder das Signal niedrigerer Frequenz als Taktsignal zugeführt wird, hängt davon ab, ob der Pegel des Audiosignals gerade ansteigt oder abfällt. Diese Schaltung zum Liefern der Taktsignale ist nicht wesentlich für das Verständnis der vorliegenden Erfindung und soll hier nicht näher erläutert werden.

Erfindungsgemäß wird aus dem abgezweigten Audiosignal ein Nachführsignal gebildet, welches mit einem Referenzsignal verglichen wird. In einer besonderen Ausgestaltung der Erfindung ist vorgesehen, daß die hierzu verwendete Signalverarbeitungsschaltung folgende Merkmale aufweist:
- einen Gleichrichter, der das Audiosignal gleichrichtet und gegebenenfalls die getrennten Signale für den linken und den rechten Kanal addiert;
- einen logarithmischen Verstärker, der an den Ausgang des Gleichrichters angeschlossen ist, und
- ein Tiefpaßfilter am Ausgang des logarithmischen Verstärkers.

Der logarithmische Verstärker dient in an sich bekannter Weise zur Anpassung der Lautstärkeveränderung an das Lautstärkeempfinden des menschlichen Ohrs. Das dem Verstärker nachgeschaltete Tiefpaßfilter glättet das Signal, so daß es sich für einen Vergleich mit dem (sich ändernden) Referenzsignal eignet.

Der in dem Komparator vorgenommene Vergleich zwischen dem Nachführsignal und dem Referenzsignal wird dadurch gegenüber restlichen Störungen im Nachführsignal unempfmdlich gemacht, daß ein Fensterkomparator verwendet wird. Solche Fensterkomparatoren (Window Comparator) sind an sich bekannt. Sie liefern ein entsprechendes Vergleichssignal an ihrem Ausgang, wenn das mit dem Referenzsignal verglichene Signal (hier: das Nachführsignal) außerhalb eines Fensters liegt, dessen Mitte durch das Referenzsignal gebildet ist.

Einen erfindungsgemäßen Signalkomprimierer kann man auch zum sogenannten "Anti-Clipping" einsetzen. Unter Clipping versteht man den Effekt, daß Signale, die aufgrund zu hoher Dynamik oder Signalstärke bis über Pegelwerte hinausgehen, die den positiven und negativen Spannungsversorgungswerten entsprechen, eine Amplitudenbegrenzung bei diesen Spannungsversorgungswerten erfahren. Es ist üblich, Signal-Endstufen oder -leistungsstufen mit einer Vorrichtung auszubilden, welche ein den Klirrfaktor anzeigendes Klirrfaktorsignal liefert. Dieses kann auf den erfindungsgemäßen Signalkomprimierer gegeben werden, mittels welchem das der Clipping-Gefahr unterliegende Signal je nach Art des Klirrfaktorsignals bei Annäherung an den Clipping-Bereich abgesenkt und, wenn dieser Bereich wieder verlassen ist, wieder angehohen wird.

Der erfindgungsgemäße Signalkomprimierer kann auch im Zusammenhang mit einer geräuschabhängigen Lautstärkeanpassung verwendet werden, beispielsweise bei einem Autoradio. Mittels eines Mikrofons wird die Hintergrundgeräusch-Lautstärke ermittelt und ein resultierendes Hintergrundgeräusch-Signal auf den Signalkomprimierer gegeben, um das Audiosignal je nach Stärke des Hintergrundgeräusches anzuheben oder abzusenken bzw. zu dekomprimieren oder zu komprimieren.

Im folgenden werden Ausführungsbeispiele der Erfindung anhand der Zeichnung näher erläutert. Es zeigen:
- **Fig. 1**: ein schematisches Diagramm einer Ausführungsform einer erfindungsgemäßen Signalkomprimierschaltung, und
- **Fig. 2**: ein schematisches Diagramm einer alternativen Ausführungsform für den rechts von der strichpunktierten Linie S in Fig. 1 dargestellten Schaltungsteil.

Im folgenden soll zunächst die bereits bekannte digital angesteuerte Lautstärkeregelung beschrieben werden, wie sie im einzelnen in der bereits erwähnten DE-A-195 27 338 beschrieben ist.

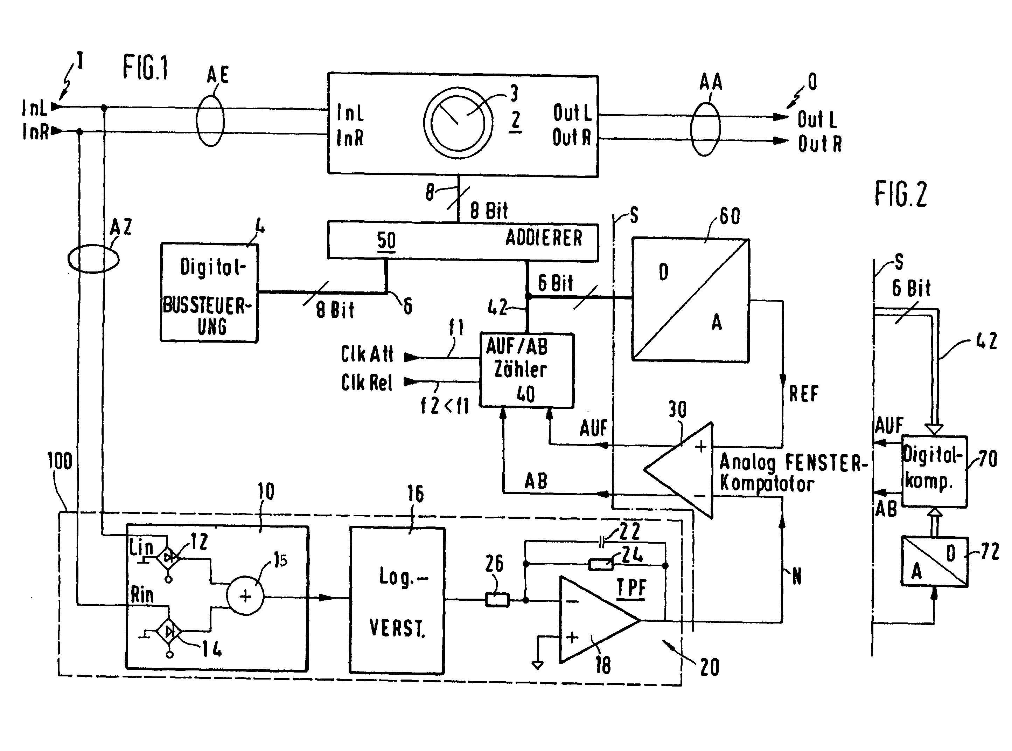

Von beispielsweise einem CD-Player kommt ein analoges, nicht-komprimiertes Signal, getrennt für die beiden Stereokanäle (L, R) am Eingang I der Schaltung nach Fig. 1 an. Über die Audiosignal-Eingangsleitung AE gelangt das Signal an einen Lautstärkeregler 2, der den Pegel des empfangenen Signals abhängig davon ändert, welchen Wert das ihm über einen 8 Bits umfassenden Signalbus 8 zugeführte digitale Stellsignal hat. Das digitale Stellsignal hängt ab von der vom Benutzer vorzunehmenden Lautstärkeeinstellung, hier angedeutet durch einen Stellknopf 3. Die Umsetzung des eingestellten Werts in den digitalen Stellwert ist hier nicht von Interesse. Das Ergebnis jeder Lautstärkeeinstellung besteht darin, daß eine digitale Bussteuerung 4 über einen 8 Bits umfassenden Signalbus 6 und den bereits erwähnten Signalbus 8 ein digitales Stellsignal an den Lautstärkeregler 2 gibt, wobei der Lautstärkeregler 2 dann abhängig vom Wert des digitalen Stellsignals den Pegel des Audiosignals ändert. Das Ausgangssignal des Lautstärkereglers 2 gelangt als Audio-Ausgangssignal AA an den zwei Kanäle umfassenden Ausgang O.

Die oben in Verbindung mit Fig. 1 erläuterten Merkmale sind bereits bekannt.

Im folgenden soll eine erste Ausführungsform des erfindungsgemäßen Signalkomprimierers beschrieben werden, der von den bereits vorhandenen, bekannten Komponenten, insbesondere dem Lautstärkeregler 2, Gebrauch macht.

Von dem Audiosignal-Eingang AE wird ein Signalzweig AZ zu einem Spitzenwert-Gleichrichter 10 abgezweigt, der in einer durch einen gestrichelten Kasten angedeuteten Signalverarbeitungseinrichtung 100 enthalten ist.

Der Spitzenwert-Gleichrichter enthält für die beiden Kanäle L und R jeweils einen Gleichrichter 12 bzw. 14. Die gleichgerichteten Signale werden von einem Summierglied 16 summiert und einem logarithmischen Verstärker 16 zugeführt. Die Ausgestaltung des analog arbeitenden logarithmischen Verstärkers 16 ist auf dem einschlägigen technischen Gebiet bekannt und braucht hier nicht mehr erläutert zu werden. Der Verstärker dient dazu, die Pegel des Audiosignals anzupassen an das subjektive Lautstärkeempfinden des menschlichen Ohrs.

Das Ausgangssignal des logarithmischen Verstärkers 16, welches immer noch mit einer gewissen Welligkeit behaftet ist, wird über ein Tiefpaßfilter (TPF) 20 geführt, um die Welligkeiten noch weiter zu verringern.

Das Tiefpaßfilter TPF 20 ist, ebenso wie der Gleichrichter 10 und der logarithmische Verstärker 16, Bestandteil der Signalverarbeitungsschaltung 100. Das Tiefpaßfilter 20 besteht aus einem Operationsverstärker 18, dessen invertierender Eingang mit seinem Ausgang über eine Parallelschaltung aus einer Kapazität 22 und einem Widerstand 24 gekoppelt ist. Zwischen dem Verstärker 16 und dem invertierenden Eingang des OP-Verstärkers 18 liegt noch ein Widerstand 26.

Der Ausgang der Signalverarbeitungsschaltung 100, das heißt das Signal am Ausgang des OP-Verstärkers 18 wird hier als Nachführsignal bezeichnet, weil es sich entsprechend dem Verlauf des Audiosignals am Audiosignal-Eingang AE ändert, hier im umgekehrten Verhältnis zur Änderung des Audiosignals. Das Nachführsignal N ist ein sich langsam änderndes Signal, welches noch mit einigen Rest-Welligkeiten behaftet ist. Das Nachführsignal N wird von einem Analog-Fensterkomparator 30 mit einem Referenzsignal REF verglichen. Solange das Nachführsignal N oberhalb des das Referenzsignal REF zentrisch umgebenden Fensters liegt, gibt der Komparator 30 ein Aufwärtszählsignal AUF an einen Auf/Ab-Zähler 40. Ist das Signal REF größer als das Nachführsignal N, liefert der Komparator 30 ein Abwärtszählsignal AB an den Zähler 40.

Das Referenzsignal REF wird gebildet aus dem Zählerstand des Zählers 40, dessen Ausgang über eine 6-Bit-Leitung mit einem Digital-Analog-Wandler (D/A-Wandler) 60 gekoppelt ist. Außerdem gelangt der Zählerstand aus dem Zähler 40 auf einen Eingang eines Addierers 50, dessen anderem Eingang von der Digital-Bussteuerung 4 das digitale Stellsignal über die Busleitung 6 zugeführt wird.

Der Auf-/Ab-Zähler 40 zählt in Abhängigkeit eines Taktsignals (CLK) aufwärts oder abwärts, abhängig davon, ob er einen hohen Pegel des Signals AUF oder einen hohen Pegel des Signals AB empfängt. Das Taktsignal besteht alternativ aus einem Taktsignal ClkAtt mit einer Frequenz f1 oder einem Taktsignal ClkRel mit der Frequenz f2, die kleiner ist als die Frequenz f1.

Der Grund für verschiedene Taktsignale besteht darin, daß der Zähler bei einem ansteigenden Audiosignal seinen Zählerstand schneller ändern soll als bei einem abfallenden mittleren Signalpegel des Audiosignals. Diese Umstände sind hier durch die verwendeten Taktsignalkürzel berücksichtigt (ATT = Attack = Anstieg; REL = Release = Abklingen).

Wie durch die nachfolgende Beschreibung noch deutlich werden wird, wird durch die zwei unterschiedlich schnellen Taktsignale erreicht, daß ein Unterdrücken großer Lautstärke rascher einsetzt als ein Anheben der Lautstärke bei schwächer werdendem Audiosignal.

Im folgenden soll angenommen werden, der sechsstellige Zähler 40 enthalte gerade einen Mittelwert "30" zwischen seinem Minimumwert "0" und seinem Maximumwert "63". Weiterhin soll bei der nachfolgenden Beschreibung der Arbeitsweise der Schaltung der Fall angenommen werden, das Audiosignal am Audiosignaleingang AE nähme einen zunehmend höheren Pegel an, um dann auf einem sehr hohen Pegel zu verbleiben. Der umgekehrte Fall eines schwächer werdenden Audiosignals braucht dann nicht noch einmal im einzelnen erläutert zu werden, da der Arbeitsablauf in umgekehrtem Sinn erfolgt.

Das relativ hohe Audiosignal wird über den Audiosignal-Zweig AZ der Signalverarbeitungsschaltung 100 zugeführt. Der Spitzenwertgleichrichter 10 bildet ein gleichgerichtetes Summensignal, welches von dem logarithmischen Verstärker 16 logarithmisch verstärkt wird. Das Ausgangssignal des logarithmischen Verstärkers wird über das Tiefpaßfilter (TPF) 20 geführt, und das so erhaltene Nachführsignal N wird mit einem Referenzwert REF verglichen, der von dem D/A-Wandler 60 aus dem Zählerstand "30" im Zähler 40 gebildet wurde. Aufgrund des relativ hohen Signalpegels des Audiosignals ist das Nachführsignal N so niedrig, daß es unterhalb des Fensters liegt, welches durch das in der Fenstermitte liegende Referenzsignal REF definiert wird. Folglich liefert der Komparator 30 ein Abwärtszählsignal AB an den Auf-/Ab-Zähler 40, der dann durch das Taktsignal mit der Frequenz f1 um "1" vermindert wird. Hierdurch verringert sich wiederum über den D/A-Wandler 60 der Referenzwert REF. Dieser Vorgang hält so lang an, bis das Nachführsignal N in dem Fenster des Fensterkomparators liegt.

Während des oben geschilderten Vorgangs wird der Zählerstand des Zählers 40 laufend über den Addierer 50 auf das digitale Stellsignal auf der Leitung 60 addiert, so daß der dem Lautstärkeregler 2 zugeführte digitale Stellwert laufend verringert wird. Im Extremfall erreicht der Zählerstand des Zählers 40 bei sehr starken Pegeln des Audiosignals seinen Minimumwert, so daß die Lautstärke durch den Lautstärkeregler 2 nur noch entsprechend dem digitalen Stellsignal von der Digital-Bussteuerung 4 bestimmt wird.

Sinkt das Audiosignal auf einen sehr niedrigen Pegel ab, steigt gegensinning dazu das Nachführsignal N an, so daß der Komparator 30 eine Reihe von Aufwärts-Zählsignalen AUF liefert, wodurch der Auf-/Ab-Zähler 40 laufend erhöht wird. Dementsprechend wird auch die durch den Addierer 50 gebildete Summe erhöht, und dementsprechend wird auch von dem Lautstärkeregler 2 die Lautstärke erhöht.

Im Ergebnis wird also bei leisen Teilen eines Musikstücks eine Anhebung der Lautstärke erreicht. Bei sehr lauten Teilen eines Musikstücks erfolgt eine Verringerung der Lautstärke.

Die Erfindung ist nicht auf das oben beschriebene Ausführungsbeispiel beschränkt. Es sind mehrere Abwandlungen möglich, von denen einige im folgenden kurz angesprochen werden sollen:

Der rechts in Fig. 1 dargestellte Schaltungsteil mit dem D/A-Wandler 60, dem Analog-Fensterkomparator 30 und dem von dem Tiefpaßfilter 20 kommenden Leitungszweig für das Nachführsignal N kann durch die in Fig. 2 dargestellte Schaltung ersetzt werden. Der Analog-Fensterkomparator 30 ist ersetzt durch einen Digital-Komparator 70, der das Ausgangssignal des Zählers 40 direkt vergleichen kann mit einem Digitalsignal, welches von einem Analog-/Digital-Wandler (A/D-Wandler) 72 aus dem Nachführsignal N gewonnen wird.

Anstelle des in Fig. 1 gezeigten Addierers 50 kann auch ein Subtrahierer verwendet werden. Dementsprechend muß dann der Zähler bei hohen Audiosignal-Pegeln erhöht und bei schwachen Audiosignal-Pegeln verringert werden, damit im Endergebnis leise Musikstücke relativ etwas lauter und laute Musikstücke relativ etwas leiser wiedergegeben werden.

In einer weiteren Abwandlung kann der Addierer 50 aus Fig. 1 ersetzt werden durch einen Multiplizierer, der das digitale Stellsignal auf der Busleitung 6 mit dem gegebenenfalls linear angepaßten Inhalt des Zählers 40 multipliziert, und zwar in der Weise, daß bei mittleren Signalpegeln etwa der durch die Digital-Bussteuerung 4 vorgegebene Wert des digitalen Stellsignals auf den Lautstärkeregler 9 gelangt, während bei niedrigen Pegeln des Audiosignals eine Multiplikation mit einem Wert größer als 1 (zum Beispiel 1,01 - 1,15) zwecks Erhöhung der Lautstärke erfolgt, und bei höheren Signalpegeln des Audiosignals eine Multiplikation mit einem Faktor kleiner als 1 erfolgt (zum Beispiel mit einem Faktor zwischen 0,85 und 0,99), damit die Lautstärke verringert wird.

## Patentansprüche

1. Signalkomprimierer für ein Audiogerät, insbesondere ein Kraftfahrzeug-Audiogerät, welches einen in den Audiosignalweg eingefügten Lautstärkeregler (2) enthält, der über ein digitales Stellsignal einstellbar ist, das von einem digitalen Steller (4) geliefert wird,
**gekennzeichnet durch** folgende Merkmale:
a) von dem Audiosignalweg vor dem Lautstärkeregler wird das Audiosignal abgezweigt und von einer Signalverarbeitungsschaltung (100) zu einem Nachführsignal (N) verarbeitet, welches von der Stärke des Audiosignals abhängt;
b) das Nachführsignal wird in einem Komparator (30; 70) mit einem Referenzwert (REF) verglichen;
c) abhängig von dem Vergleichsergebnis wird ein als Auf-/Ab-Zähler ausgebildeter Zähler (40) erhöht oder erniedrigt; und
d) der Inhalt des Zählers wird mit dem digitalen Stellsignal verknüpft, bevor das Stellsignal dem Lautstärkeregler (2) zugeführt wird.

2. Signalkomprimierer nach Anspruch 1,
**dadurch gekennzeichnet, daß** ein Addierer (50) als Verknüpfungsglied vorgesehen ist, auf dessen ersten Eingang das digitale Stellsignal gegeben wird, und dessen zweiter Eingang mit dem Ausgang des Zählers (40) gekoppelt ist, wobei der Zähler von dem Ausgangssignal des Komparators (30, 70) erhöht wird, wenn das Nachführsignal (N) einer Verringerung des Pegels des Audiosignals entspricht.

3. Signalkomprimierer nach Anspruch 1,
**dadurch gekennzeichnet, daß** ein Subtrahierer vorgesehen ist, auf dessen ersten Eingang das digitale Stellsignal gegeben wird, und dessen zweiter Eingang mit dem Ausgang des Zählers gekoppelt ist, wobei der Zähler von dem Ausgangssignal des Komparators erniedrigt wird, wenn das Nachführsignal einer Verringerung des Pegels des Audiosignals entspricht.

4. Signalkomprimierer nach einem der Ansprüche 1 bis 3,
**dadurch gekennzeichnet, daß** der als Analogvergleicher ausgebildete Komparator (30) mit einem Eingang über einen D/A-Wandler an den Ausgang des Zählers (40) und mit seinem anderen Eingang an den Ausgang der Signalverarbeitungsschaltung angeschlossen ist.

5. Signalkomprimierer nach einem der Ansprüche 1 bis 3,
**dadurch gekennzeichnet, daß** der als Digitalvergleicher ausgebildete Komparator (70) mit einem Eingang über einen A/D-Wandler (72) an den Ausgang der Signalverarbeitungsschaltung und mit dem anderen Eingang an den Ausgang des Zählers (40) angeschlossen ist.

6. Signalkomprimierer nach einem der Ansprüche 1 bis 5,
**dadurch gekennzeichnet, daß** der Ausgang des Komparators mit einem Zählrichtungseingang des Zähler (40) gekoppelt ist, und daß der Zähler abhängig davon, ob die Audiosignal-Stärke zunimmt oder abnimmt, mit einem Taktsignal einer ersten Frequenz bzw. einem Taktsignal einer zweiten Frequenz, die niedriger ist als die erste Frequenz, getaktet wird.

7. Signalkomprimierer nach einem der vorhergehenden Ansprüche,
**dadurch gekennzeichnet, daß** die Signalverarbeitungsschaltung aufweist:
- einen Gleichrichter (10), der das Audiosignal gleichrichtet und gegebenenfalls die getrennten Signale für den linken und den rechten Kanal addiert;
- einen logarithmischen Verstärker (16), der an den Ausgang des Gleichrichters angeschlossen ist, und
- ein Tiefpaßfilter (20) am Ausgang des logarithmischen Verstärkers.

8. Verwendung eines Signalkomprimierers nach einem der Ansprüche 1 bis 7 für eine Anti-Clipping-Schaltung zur Verhinderung der Amplitudenbeschneidung eines Nutzsignals, dessen Signalamplitude in den Bereich des positiven oder negativen Spannungswertes einer Spannungsversorgungsquelle kommt, wobei das Nutzsignal durch den Signalkomprimierer geschickt und dessen Signalkompressionsgrad oder Signaldekompressionsgrad in Abhängigkeit von einem Klirrfaktorsignal gesteuert wird, das aus einem nicht durch den Signalkomprimierer geschickten Abzweiganteil des Nutzsignals gewonnen wird.

9. Verwendung eines Signalkomprimierers nach einem der Ansprüche 1 bis 7 für eine geräuschabhängige Lautstärkeanpassung eines Audiosignals, wobei ein der Stärke eines Hintergrundgeräusches entsprechendes Hintergrundgeräuschsignal gewonnen und in dessen Abhängigkeit der Pegel des Audiosignals mittels des Signalkomprimierers angehoben oder abgesenkt wird.

## Claims

1. A signal compressor for an audio apparatus, in particular a motor vehicle audio apparatus, which contains a volume control (2) that is inserted in the audio signal path and is adjustable via a digital setting signal which is delivered by a digital controller (4),
**characterised by** the following features:
a)the audio signal is branched off from the audio signal path upstream of the volume control and is processed by a signal processing circuit (100) so as to form a tracking signal (N) that is dependent on the intensity of the audio signal;
b) the tracking signal is compared in a comparator (30; 70) with a reference value (REF);
c)depending on the comparison result, a counter (40) designed as up/down counter is increased or decreased; and
d)the contents of the counter are linked with the digital setting signal before the setting signal is fed to the volume control (2).

2. The signal compressor of claim 1,
wherein an adder (50) is provided as link means receiving on its first input the digital setting signal and having its second input coupled with the output of the counter (40), the counter having its count raised by the output signal of the comparator (30, 70) when the tracking signal (N) corresponds to a reduction of the level of the audio signal.

3. The signal compressor of claim 1,
wherein a subtracter is provided receiving on its first input the digital setting signal and having its second input coupled with the output of the counter, the counter having its count lowered by the output signal of the comparator when the tracking signal corresponds to a reduction of the level of the audio signal.

4. The signal compressor of any of claims 1 to 3,
wherein the comparator (30) designed as analogue comparator has one input connected to the output of the counter (40) via a D/A converter and has its other input connected to the output of the signal processing circuit.

5. The signal compressor of any of claims 1 to 3,
wherein the comparator (70) designed as digital comparator has one input connected to the output of the signal processing circuit via an A/D converter (70) and has its other input connected to the output of the counter (40).

6. The signal compressor of any of claims 1 to 5,
wherein the output of the comparator is coupled with a counting direction input of the counter (40), and wherein the counter, depending on whether the audio signal intensity increases or decreases; is clocked with a clock signal having a first frequency and, respectively, a clock signal having a second frequency that is lower than said first frequency.

7. The signal compressor of any of the preceding claims,
wherein the signal processing circuit comprises:
- a rectifier (10) rectifying the audio signal and, if applicable, adding the separate signals for the left and the right channels;
- a logarithmic amplifier (16) connected to the output of the rectifier, and
- a low pass filter (20) at the output of the logarithmic amplifier.

8. The use of a signal compressor of any of claims 1 to 7 for an anti-clipping circuit for preventing amplitude clipping of a useful signal the signal amplitude of which enters into the range of the positive or negative voltage value of a voltage supply source, the useful signal being passed through the signal compressor and the degree of signal compression or signal decompression thereof being controlled in accordance with a harmonic distortion signal obtained from a branched-off portion of the useful signal that has not been passed through the signal compressor.

9. The use of a signal compressor of any of claims 1 to 7 for noise-dependent volume matching of an audio signal, in which a background noise signal corresponding to the strength of a background noise is obtained and in accordance with which the level of the audio signal is increased or decreased by means of the signal compressor.

## Revendications

1. Compresseur de signaux pour un appareil audio, en particulier un appareil audio de véhicule automobile, qui contient un organe de réglage du volume (2) inséré dans la voix des signaux audio, lequel est réglable au moyen d'un signal de réglage numérique qui est fourni par un organe de réglage numérique (4), **caractérisé par** les caractéristiques suivantes :
a) le signal audio est dérivé de la voix des signaux audio en amont de l'organe de réglage du volume, et est transformé par un circuit de traitement des signaux (100) en un signal de poursuite (N) qui dépend de l'intensité du signal audio ;
b) le signal de poursuite est comparé dans un comparateur (30 ; 70) à une valeur de référence (REF) ;
c) en fonction du résultat de la comparaison, un compteur (40) réalisé comme compteur progressif/dégressif est relevé ou abaissé ; et
d) le contenu du compteur est relié au signal de réglage numérique avant que le signal de réglage ne soit envoyé à l'organe de réglage du volume (2).

2. Compresseur de signaux selon la revendication 1, **caractérisé en ce qu'**il est prévu un sommateur (50) comme élément logique à la première entrée duquel est appliqué le signal de réglage numérique et dont la deuxième entrée est couplée à la sortie du compteur (40), le compteur (40) étant relevé par le signal de sortie du comparateur (30, 70) lorsque le signal de poursuite (N) correspond à une réduction du niveau du signal audio.

3. Compresseur de signaux selon la revendication 1, **caractérisé en ce qu'**il est prévu un soustracteur à la première entrée duquel est appliqué le signal de réglage numérique et dont la deuxième entrée est couplée à la sortie du compteur, le compteur étant abaissé par le signal de sortie du comparateur lorsque le signal de poursuite correspond à une réduction du niveau du signal audio.

4. Compresseur de signaux selon l'une des revendications 1 à 3, **caractérisé en ce que** le comparateur (30), réalisé comme comparateur analogique, est raccordé par une entrée, par l'intermédiaire d'un convertisseur numérique/analogique, à la sortie du compteur (40) et par son autre entrée, à la sortie du circuit de traitement des signaux.

5. Compresseur de signaux selon l'une des revendications 1 à 3, **caractérisé en ce que** le comparateur (70), réalisé comme comparateur numérique, est raccordé par une entrée, par l'intermédiaire d'un convertisseur analogique/numérique (72), à la sortie du circuit de traitement des signaux et, par l'autre entrée, à la sortie du compteur (40).

6. Compresseur de signaux selon l'une des revendications 1 à 5, **caractérisé en ce que** la sortie du comparateur est couplée à une entrée de sens de comptage du compteur (40), et **en ce que** le compteur est rythmé suivant que l'intensité du signal audio augmente ou diminue, avec un signal de rythme d'une première fréquence ou un signal de rythme d'une deuxième fréquence qui est inférieure à la première fréquence.

7. Compresseur de signaux selon l'une des revendications précédentes, **caractérisé en ce que** le circuit de traitement des signaux comporte :
- un redresseur (10) qui redresse le signal audio et additionne éventuellement les signaux séparés pour le canal gauche et le canal droit ;
- un amplificateur logarithmique (16) qui est raccordé à la sortie du redresseur, et
- un filtre passe-bas (20) à la sortie de l'amplificateur logarithmique.

8. Utilisation d'un compresseur de signaux selon l'une des revendications 1 à 7 pour un circuit d'anti-clipping afin d'empêcher la coupure d'amplitude d'un signal utile dont l'amplitude parvient dans le domaine de la valeur positive ou négative de la tension d'une source d'alimentation en tension, le signal utile étant envoyé par le compresseur de signaux et son degré de compression ou degré de décompression des signaux étant commandé en fonction d'un signal de distorsion harmonique qui est obtenu à partir d'une composante de dérivation, non envoyée par le compresseur de signaux, du signal utile.

9. Utilisation d'un compresseur de signaux selon l'une des revendications 1 à 7 pour une adaptation du volume dépendant du bruit d'un signal audio, un signal de bruit de fond correspondant à l'intensité d'un bruit de fond étant obtenu et, en fonction de celui-ci, le niveau du signal audio étant relevé ou abaissé au moyen du compresseur de signaux.
